# EUROPEAN PATENT APPLICATION

(11) **EP 4 769 216 A1**
(43) Date of publication of application: **01.07.2026**
(21) Application number: 24307299.8
(22) Date of filing: 24.12.2024
(51) Int. Cl.: G06K 19/077, H01L 21/00

(54) **DUAL INTERFACE MODULE AND SMARTCARD COMPRISING SAID MODULE**

(71) Applicant: THALES DIS FRANCE SAS, 92190 Meudon (FR)
(72) Inventor: OTTOBON, Stephane, 83270 Saint Cyr Sur Mer (FR); DOSSETTO, Lucile, 83270 Saint Cyr Sur Mer (FR)
(74) Representative: Castelo, Jérôme

(57) **Abstract**

The invention relates to a smartcard dual-interface module comprising an IC (300) and a single side PCB (100) comprising a conductive layer and an insulating layer. The conductive layer is engraved with a first and second series of contact areas (101 to 106, A1, A2). The first series of contact areas (101 to 106) are intended to be connected to a contact reader. The second series of contact areas (A1, A2) being intended to connect an antenna (610) located inside a smartcard body (600). The first and second series of contact areas (101 to 106, A1, A2) are connected to the IC (300) by means of wires (400) crossing the insulating layer through holes (201, 202). The insulating layer comprises a single hole (202) for each contact area of the second series of contact areas (A1, A2) for connecting both the antenna (610) and the IC (300).

## Description

### Technical Field

The invention relates to a dual interface module and a smartcard integrating said module.

### Background Art

A smartcard can communicate with a reader either by a contact interface, or by a contactless interface or both, known as dual interface smartcard. A dual interface smartcard comprises a card body including an antenna and a cavity into which a dual interface module is inserted. The interface module comprises a printed circuit board (PCB) carrying on a first side contacts areas for contacting a contact reader and, on an opposite side an integrated circuit (IC) and contact areas for connecting the antenna included in the card body. The contact areas are connected to the IC with gold wires passing through holes into an insulating layer.

A first kind of dual interface module uses double side PCB having holes in the insulating layer carrying the contact area in such a way to connect the IC with the contact areas located on the other side. But double side PCB are relatively expensive with regards to single side PCB. In addition, the module is relatively thick. So, there was an idea to make dual interface module with single side PCB.

US 5,598,032 proposes a dual interface module using a single side PCB. The dual interface module of this patent application uses two additional contact areas on the front face of the PCB. The insulating layer of the PCB comprises two holes for each of these additional contacts. A first of the holes is located close to the IC in such a way to connect the IC to the first additional contacts with gold wires. A second of the holes is located outside the protection resin covering the IC in such a way to connect the additional contact areas to the antenna of the card body.

Another dual interface module using single side PCB is disclosed by FR 3 047 101. In this patent application, a connection of gold wires corresponding to the antenna are connected from the IC to holes in the insulating layer but outside the area of the module. Then, an adhesive layer recovers the back of the module after wire bonding. The adhesive layer comprises holes around the positions of the gold wires corresponding the antenna. But the addition of the adhesive layer necessitates an additional step in the manufacturing process.

European patent EP 3 059 698 discloses another method for making a dual interface on a single side PCB. In this patent, the antenna contact is made using conductive bumps. The conductive bumps are connected to the IC through gold wires crossing the bumps. But for doing such connection the gold wires are first connected outside the area of the module. Such a method of manufacturing uses more gold wires than necessary and is relatively expensive.

None of these solutions of dual interface module using a single side PCB is perfect and other solutions are needed.

### Summary of the Invention

The invention aims to provide a new dual interface module using a single side PCB. In the proposed invention two external contacts are used for connecting the antenna. For each contact used for antenna connection, the insulating layer comprises a single hole for both connecting the antenna and the IC with a wire. More particularly, the invention provides a smartcard dual-interface module comprising an integrated circuit (IC) and a single side printed circuit board (PCB) comprising a conductive layer and an insulating layer. The conductive layer is engraved with a first series of contact areas and a second series of contact areas, the first series of contact areas being intended to be connected to a contact reader and the second series of contact areas being intended to connect an antenna located inside a smartcard body, the IC being stuck on the insulating layer of the single side PCB and covered by a protection layer. The first and second series of contact areas are connected to the IC by means of wires crossing the insulating layer through holes. The insulating layer comprises a single hole for each contact area of the second series of contact areas for connecting through the insulating layer both the antenna and the IC.

Preferentially, the holes associated with the second series of contact areas are located outside the protection layer.

In a preferred embodiment, each contact area of the second series of contact areas is located between two contact areas of the first series of contact areas.

More particularly, the first series of contact areas can correspond respectively to contact areas C1, C2 C3, C5, C6 and C7 defined in the ISO7816 standard, and wherein one of the contact areas of the second series of contact areas is located between contact areas C1 and C5, and another of the contact areas of the second series of contact areas is located between contact areas C3 and C7.

The invention is also a dual-interface smartcard comprising a card body including an antenna and a dual-interface module, wherein the dual-interface module is a smartcard dual-interface module according to the invention.

In a preferred embodiment, the second series of contact areas can be connected to the antenna with conductive material, said conductive material embedding part of the wires connected to said second series of contact areas.

According to another aspect, the invention is a method for manufacturing a smartcard dual-interface module comprising the steps of:
- providing a single side printed circuit board comprising a conductive layer and an insulating layer wherein the conductive layer is engraved with a first series of contact areas and a second series of contact areas and wherein the insulating layer comprises a single hole in front of each contact area of the first and second series of contact areas,
- sticking an integrated circuit (IC) on the insulating layer,
- linking each contact area of the first and second series of contact areas to a contact pad of the IC with a wire passing through the hole,
- covering the IC with a protection layer, said protection layer covering the holes corresponding to the first series of contact areas and covering in part the wires of the second series of contact areas but not covering the holes corresponding to the second series of contact areas.

A method for manufacturing a smartcard wherein the method comprises the steps of:
- providing a module obtained by the previous method,
- providing a smartcard body including an antenna laminated between two external layers, said smartcard body comprising a cavity for receiving a module, said cavity having two wells in front of two contacts areas of the antenna, the wells matching with the holes of the second series of contact areas of the module obtained by the method of the invention,

- filling the wells with a conductive material and deposition of an adhesive on the module or in the cavity,
- putting the module into the cavity and pressing the module and the card body for fixing the module, the conductive glue being in contact with the second series of contact areas and embedding the corresponding wires.

### Brief description of the Drawings

The invention will be detailed with reference to the annexed drawings in which:
Figure 1 to figure 5 show a module according to the invention at different steps of manufacturing,
Figure 6 to 9 illustrate how the module of the invention is mounted into a smartcard according to the invention,
Figure 10 is a partial sectional view according to the axe A-A shown on figures 8 and 9, and
Figures 11 and 12 illustrate a variant of the invention.

### Detailed Description of the invention

In such a way to simplify the present specification, a same reference is used on different drawings for designing a same element or an equivalent element without being necessarily described in relation with each figure. For a representation reason, the drawings are not made with an exact scale for showing details that cannot be shown otherwise.

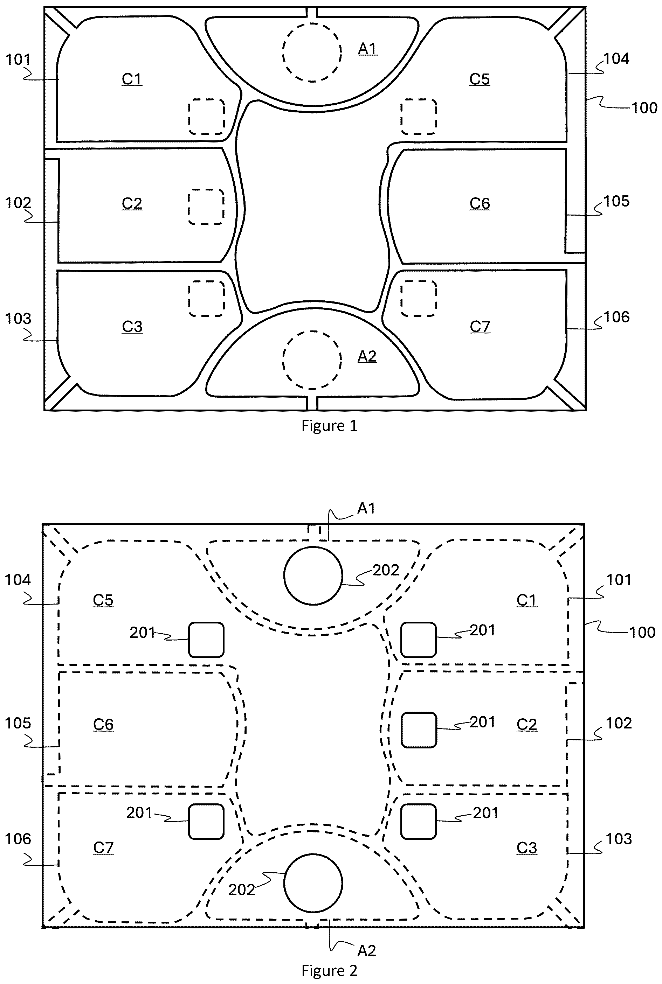

Figures 1 to 5 shows a dual-interface module according to the invention during its manufacturing process. For simplifying the drawings, only one module is shown even if the module is manufactured on a 35mm-band of printed circuit board (PCB) carrying hundreds of modules.

A first step of manufacturing consists in providing a single side PCB comprising a conductive layer and an insulating layer. The figure 1 shows the conductive face of the PCB 100 onto which contacts areas are engraved according to a known method of etching. The contact areas comprise two series of contact areas. A first series of contacts areas 101, 102, 103, 104, 105 and 106 corresponds to the six contacts areas C1, C2, C3, C5, C6 and C7 defined in the ISO7816 standard which are intended to be connected to a contact reader. A second series of contacts corresponds to the two contact areas A1 and A2 which are intended to be connected to the antenna in a smartcard body and enable to externally test the antenna path. According to this example, the contact area A1 of the second series of contact areas is located between contact areas 101 and 104, corresponding to contact areas C1 and C4, and the contact area A2 of the second series of contact areas is located between contact areas 103 and 106, corresponding to contact areas C3 and C6.

The figure 2 shows the other face corresponding to the insulating layer of the PCB 100. As it can be seen on figure 2, the insulating layer comprises a single hole 201 or 202 in front of each contact area of the first and second series of contact areas 101, 102, 103, 104, 105 and 106, A1 and A2. In this example, there is no hole for contact area 105 because contact area C6 is not used by banking smartcard. The holes 201 correspond to the contact areas 101, 102, 103, 104, and 106 of the first series of contact areas and are located close to the center of the module as well known in the art. The holes 202 correspond to the contact areas A1 and A2 of the second series of contact areas and are located far from the center of the module. In addition, the holes 202 are larger than the hole 201 because they are intended to be connected to the antenna and to wires connecting the integrated circuit. The holes 201 and 202 are made in the insulating layer according to a known method but the fact that there is only a single hole 202 for each contact areas A1 and A2 reduces the cost of the PCB 100.

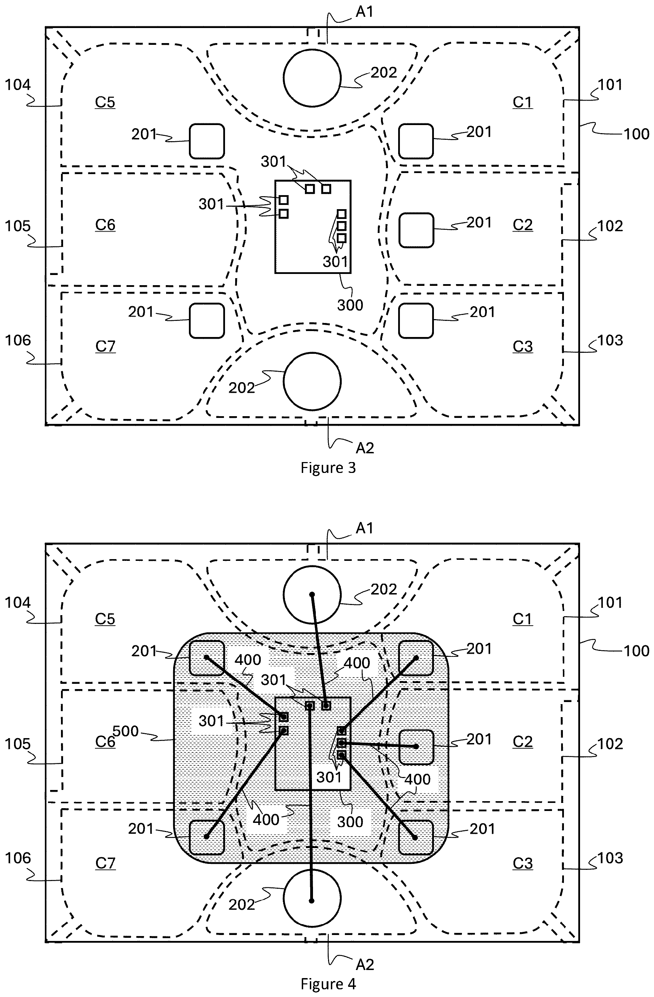

A second step consists in sticking an integrated circuit 300 (IC 300) on the insulating layer in the center of the module as shown on figure 3. The IC 300 comprises contact pads 301 located at positions enabling a direct connection with a corresponding contact area with wires without crossing of the wires. The sticking can made using glue or other means999 according to a known method.

A third step consists in the linking of each contact area 101, 102, 103, 104 and 106, A1 or A2 of the first and second series of contact areas to a corresponding contact pad 301 of the IC 300 with gold wires 400 passing through the holes 201 and 202. As shown on figure 4, each gold wire is preferably soldered in the center of each pad 301 and crushed or soldered in the center of each hole 201 or 202 to the corresponding contact area 101, 102, 103, 104 and 106, A1 or A2. Of course, the gold wires can be replaced by wires of another conductive metal having high conductivity like Silver, Copper or aluminum.

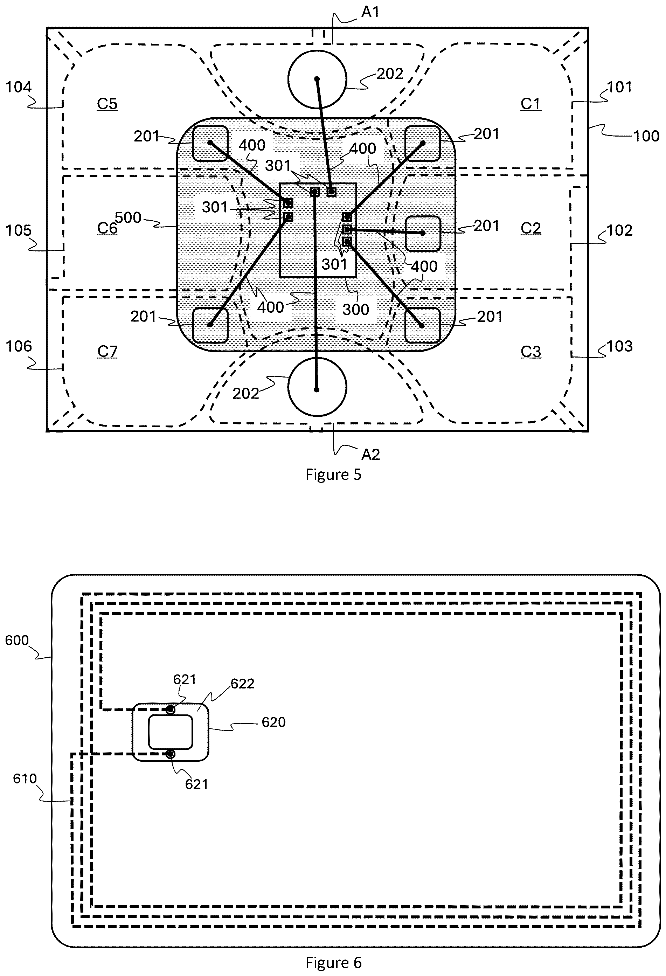

A fourth step consists in the deposition of a protection layer 500, illustrated on figure 5. The protection layer 500 covers the IC 300, the holes 201 and the gold wires 400 corresponding to the first series of contact areas 101, 102, 103, 104 and 106. A part the gold wires 400 of the second series of contact areas A1 and A2 are also covered by the protection layer 500 but not the holes 202 corresponding to the second series of contact areas A1 and A2. The deposition of the protection layer 500 can be made according to different methods of the art, for example by a simple deposition of resin which can be hardened by ultraviolet exposition.

The modules according to the invention can be rolled up after the fourth step to provide a reel of dual interface modules for inserting them in smartcard bodies. Such modules of the invention have several advantages regarding prior art modules. The number of holes 201 and 202 been limited to the total number of contacts reduces the cost of the PCB 100. The fact that the gold wires 400 of the second series of contact areas A1 and A2 are in the same holes used for connecting the antenna can improve conductivity because the connection to the antenna is be made directly on the gold wires. The fact that the holes 202 are used for connecting the antenna and for receiving the gold wires 400 enables to have more place for the holes 202 and/or sticking the IC 300.

The manufacturing of a smartcard according to the invention can be made with the previously described module.

In a first step, a smartcard body 600 is provided according to figure 6. The smartcard body includes an antenna 610 laminated between two external layers according to prior art. The smartcard body further comprises a cavity 620 for receiving a module, said cavity having two wells 621 in front of two contacts areas of the antenna on a shoulder 622 of said cavity 620. The cavity 620, the wells 621 and the shoulder 622 can be machined according to a known method but the positions of the wells 621 are defined to match with the holes 202 of the second series of contact areas A1 and A2 of the module of the invention.

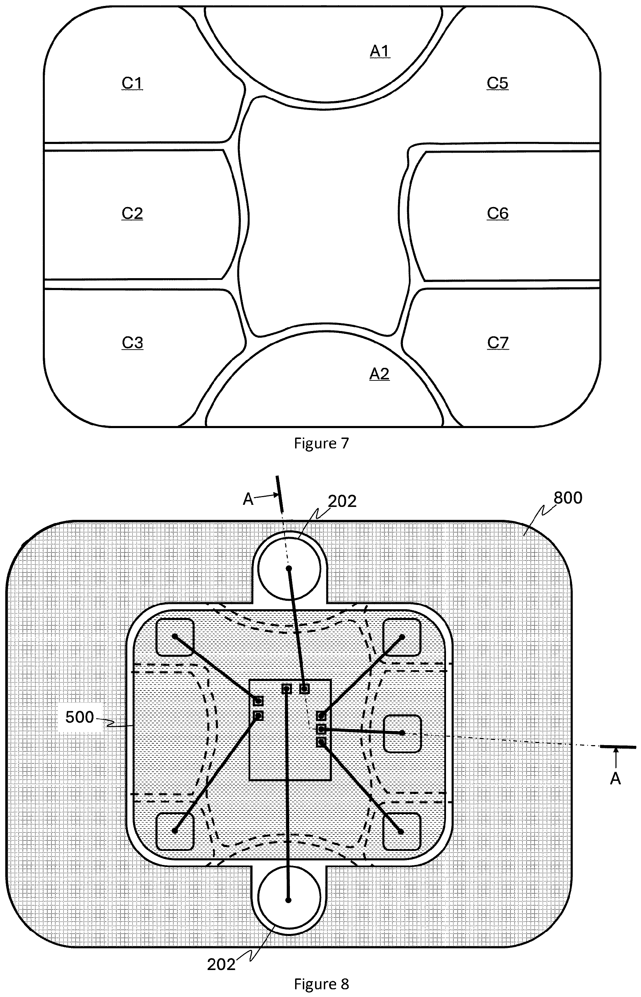

Then, in a second step, the module obtained by the previously described method is cut, as an example by punching, as shown on figure 7, to fit with the cavity 620.

To fix the module into the smartcard body 600, an adhesive is deposited on the insulating layer of the module. As an example shown on figure 8, a double side adhesive layer 800 is stuck over the insulating layer of the module in a third step. The double side adhesive layer 800 must not cover the holes 202 nor the protection layer 500. In this third step the wells 621 are filled with a conductive glue, like silver glue, said conductive glue overflowing from the wells 621.

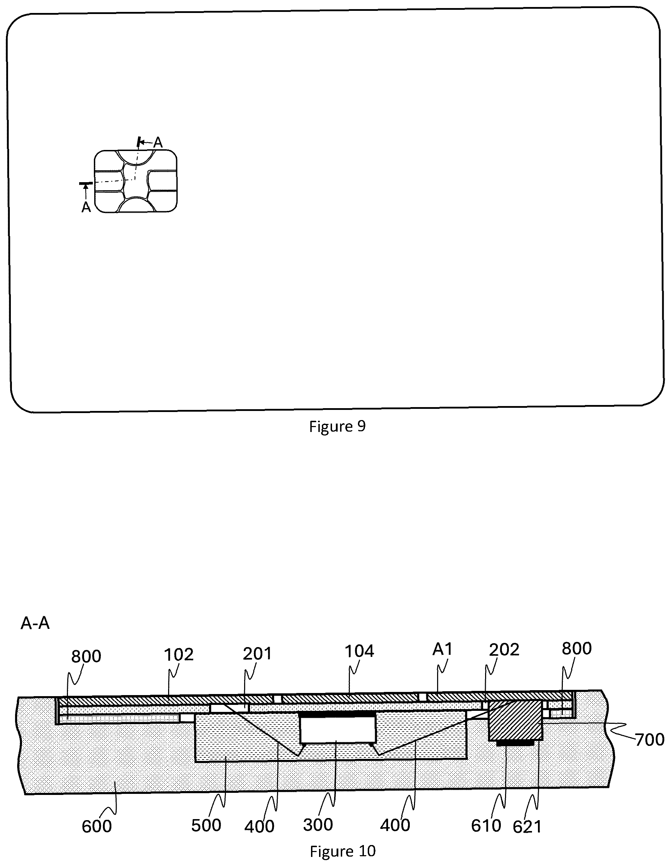

The module is then put in the cavity 620 and pressed in a fourth step for obtaining the smartcard of figures 9 and 10. The figure 10 is a partial sectional view according to the axe A-A shown on figures 8 and 9. As it can be seen on the figure 10, the conductive glue 700 embeds the wire 400 associated with the hole 202 and connects the antenna 610 and the contact area A1. It can be seen also on figure 10 that the adhesive layer 800 does not cover nor overlap the wire 400.

For the sticking of the module into the cavity several alternative and equivalent methods known from the art can be used. As an example, the adhesive layer 800 can be replaced by the deposition of a bead of cyanoacrylate glue either on the insulating layer of the module, or on the shoulder 622, or inside the cavity 620.

As another example, the conductive glue can be replaced by conductive bumps or spring deposited in the wells. Nevertheless, the use of a conductive glue enables to have a good electric contact because the silver glue embeds the gold wires 400. In addition, conductive glue reduces the risk of damaging the gold wires 400 when the module is put into the cavity 620.

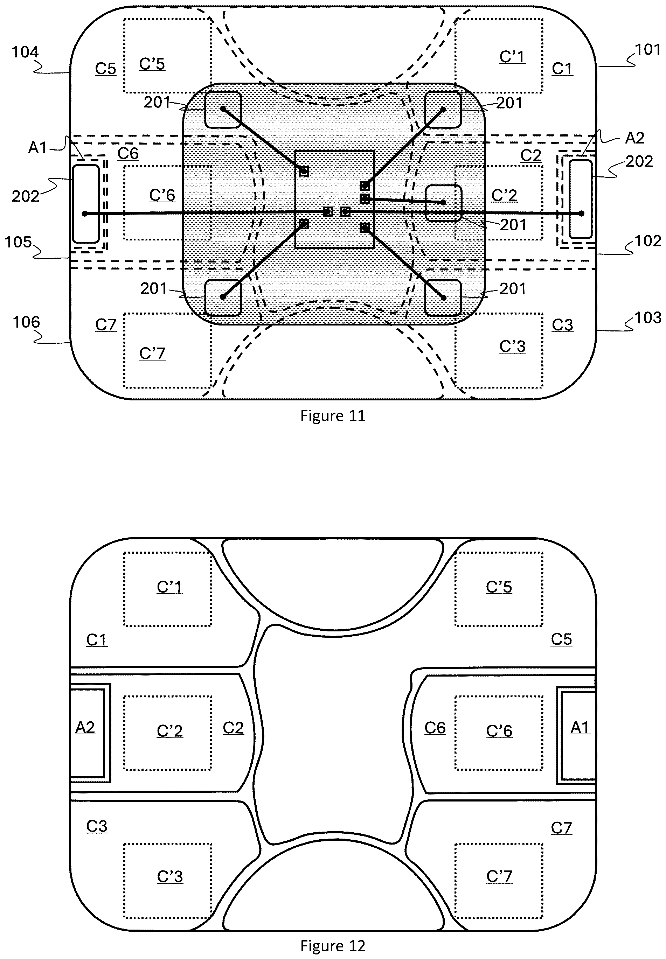

The described invention is a preferred example, but several variants of the invention are possible. In particular, the location the contact areas can be in another place than previously described. As it can be seen on figures 11 and 12, the size of the first series of contact areas 101, 102, 103, 104, 105 and 106 are larger than the size of areas C'1, C'2, C'3, C'5, C'6 and C'7 corresponding to the minimum size defined in the ISO7816 standard. It is possible to place the second series of contact areas A1 and A2 anywhere outside of areas C'1, C'2, C'3, C'5, C'6 and C'7 and outside the place of the IC 300. Another variant can be to have the holes 202 larger than those indicated in the described example. So, the holes associated with the second series of contact areas A1 and A2 can be located at least partially outside of the protection layer 500 with the wires 400 connected outside said protection layer 500.

Many other modifications are possible without departing from the claimed invention.

## Claims

1. A smartcard dual-interface module comprising an integrated circuit (300) (IC) and a single side printed circuit board (100) (PCB) comprising a conductive layer and an insulating layer, wherein the conductive layer is engraved with a first of contact areas (101, 102, 103, 104, 105, 106) and a second series of contact areas (A1, A2), the first series of contact areas (101, 102, 103, 104, 105, 106) being intended to be connected to a contact reader and the second series of contact areas (A1, A2) being intended to connect an antenna (610) located inside a smartcard body (600), the IC (300) being stuck on the insulating layer of the single side PCB (100) and covered by a protection layer (500), wherein the first and second series of contact areas (101, 102, 103, 104, 105, 106, A1, A2) are connected to the IC (300) by means of wires (400) crossing the insulating layer through holes (201, 202), **characterized in that** the insulating layer comprises a single hole (202) for each contact area of the second series of contact areas (A1, A2) for connecting through the insulating layer both the antenna (610) and the IC (300).

2. The smartcard dual-interface module according to claim 1, wherein the holes (202) associated with the second series of contact areas (A1, A2) are located outside the protection layer (500).

3. The smartcard dual-interface module according to one of the claims 1 to 2, wherein each contact area of the second series of contact areas (A1, A2) is located between two contact areas (101, 104, 103, 106) of the first series of contact areas.

4. The smartcard dual-interface module according to claim 3, wherein the first series of contact areas corresponds respectively to contact areas C1, C2 C3, C5, C6 and C7 defined in the ISO7816 standard, and wherein one (A1) of the contact areas of the second series of contact areas is located between contact areas C1 and C5 (101, 104), and another (A2) of the contact areas of the second series of contact areas is located between contact areas C3 and C7 (103, 106).

5. A dual-interface smartcard comprising a smartcard body (600) including an antenna (610) and a dual-interface module, **characterized in that** the dual-interface module is a smartcard dual-interface module according to one of the claims 1 to 4.

6. The dual-interface smartcard according to claim 5, wherein the second series of contact areas (A1, A2) are connected to the antenna (610) with conductive material, said conductive material embedding part of the wires (400) connected to said second series of contact areas (A1, A2).

7. The dual-interface smartcard according to claim 6, wherein the conductive material is silver glue.

8. The dual-interface smartcard according to one of the claims 5 to 7, wherein the smartcard dual-interface module is stuck to the smart card body with an adhesive layer (800), and wherein said adhesive layer (800) does not cover nor overlap the wires (400).

9. A method for manufacturing a smartcard dual-interface module comprising the steps of :
- providing a single side printed circuit board (100) comprising a conductive layer and an insulating layer wherein the conductive layer is engraved with a first series of contact areas (101, 102, 103, 104, 105, 106) and a second series of contact areas (A1, A2) and wherein the insulating layer comprises at most a single hole (201, 202) in front of each contact area of the first and second series of contact areas (101, 102, 103, 104, 105, 106, A1, A2),
- sticking an integrated circuit (300) (IC) on the insulating layer,
- linking each contact area of the first and second series of contact areas (101, 102, 103, 104, 105, 106, A1, A2) to a contact pad (301) of the IC (300) with a wire (400) passing through the hole (201, 202),
- covering the IC (300) with a protection layer (500), said protection layer (500) covering the holes (201) corresponding to the first series of contact areas (101, 102, 103, 104, 105, 106) and covering in part the wires (400) of the second series of contact areas (A1, A2) but not covering the holes (202) corresponding to the second series of contact areas (A1, A2).

10. A method for manufacturing a smartcard wherein the method comprises the steps of:
- providing a module obtained by the method of claim 9
- providing a smartcard body (600) including an antenna (610) laminated between two external layers, said smartcard body (600) comprising a cavity (620) for receiving a module, said cavity (620) having two wells (621) in front of two contacts areas of the antenna (610), the wells (621) matching with the holes (202) of the second series of contact areas (A1, A2) of the module,
- filling the wells (621) with a conductive glue and deposition of an adhesive on the module or in the cavity (620),
- putting the module into the cavity and pressing the module and the card body for fixing the module, the conductive glue being in contact with the second series of contact areas (A1, A2) and embedding the corresponding wires (400).
